# EUROPEAN PATENT APPLICATION

(11) **EP 4 686 699 A1**
(43) Date of publication of application: **04.02.2026**
(21) Application number: 24197466.6
(22) Date of filing: 30.08.2024
(51) Int. Cl.: C01B 25/45, H01M 4/36, H01M 10/0525

(54) **A CATHODE MATERIAL OF COMPOSITE CARBON-COATED LITHIUM MANGANESE IRON PHOSPHATE, PREPARATION METHOD, AND USE THEREOF**

(30) Priority: 29.07.2024 CN 202411020225
(71) Applicant: Hunan Huaxing Lithium Electric New Energy Co. , Ltd., Changsha City, Hunan Province 410600 (CN)
(72) Inventor: FU, Zhao, Guangzhou, 510000 (CN); TANG, Yuanlin, Shaoyang, 422900 (CN); CHEN, Hailin, Liling, 412212 (CN); XU, Changmei, Huaihua City, 419600 (CN); PENG, Peng, Liling Bridge, 412200 (CN)
(74) Representative: Valet Patent Services Limited

(57) **Abstract**

A cathode material of composite carbon-coated lithium manganese iron phosphate, preparation method, and use thereof are disclosed. The method includes steps: (1) by a coprecipitation reaction of a mixed bimetallic solution containing manganese and iron salts with an oxalic solution, and then filtering, washing and drying, to obtain a manganese iron oxalate precursor; and (2) the manganese iron oxalate precursor is mixed with a lithium source and carbon sources, and then grinding, spray drying, sintering and pulverizing, to obtain the cathode material of lithium manganese iron phosphate. This method has advantages of simple process, easy industrialized large-scale production, good economic benefits, low manufacturing cost, etc., which can effectively improve the charging/discharging specific capacity of the cathode material of lithium manganese iron phosphate. Moreover, this method also can solve the problems of poor electronic conductivity and low lithium-ion diffusion rate by coating lithium manganese iron phosphate with the composite carbon sources.

## Description

### TECHNICAL FIELD

The present application relates to the technical field of lithium-ion batteries, and specifically to a cathode material of composite carbon-coated lithium manganese iron phosphate, preparation method, and use thereof.

### BACKGROUND

As a preferred cathode material for lithium-ion batteries, lithium iron phosphate has attracted much attention. It has advantages of a long life, low price, abundant raw materials, environmentally friendly, excellent safety, and so on, and is widely used in electric vehicles, electric energy storage, wind and solar power storage, automotive auxiliary power supply and other fields.

However, lithium iron phosphate also has some problems, such as low energy density, poor low-temperature performance, etc. Lithium manganese iron phosphate as an upgraded product of lithium iron phosphate has been widely concerned, development of lithium manganese iron phosphate is imperative and of great strategic importance. Compared to lithium iron phosphate, lithium manganese iron phosphate as the cathode material may increase the battery energy density by more than 15%, and also may realize the breakthrough of the lithium-ion batteries with high specific energy, high safety, high cycle life and low cost to meet the demand of electric vehicles, which is of very-term significance for the protection of the country's energy conservation and environmental protection. Therefore, the present disclosure proposes a novel cathode material of composite carbon-coated lithium manganese iron phosphate, preparation method, and use thereof.

### SUMMARY

The present disclosure aims to provide a novel cathode material of composite carbon-coated lithium manganese iron phosphate, preparation method, and use thereof, to address problems in the existing technologies that lithium iron phosphate with low energy density and poor low temperature performance, resulting in unable to realize the breakthrough of the lithium-ion batteries with high specific energy, high safety, high cycle life and low cost to meet the demand of electric vehicles.

To achieve above objectives, the present disclosure adopts the following technical solutions.

In a first aspect, in some embodiments of the present disclosure, a method for preparing a cathode material of composite carbon-coated lithium manganese iron phosphate is disclosed, including the following steps S1 to S7.

S1, weighing a manganese salt and an iron salt according to a molar ratio, and adding deionized water to completely dissolve, to obtain a mixed bimetallic solution.

S2, weighing an oxalate according to a molar ratio of the manganese salt to the iron salt, putting the oxalate in a reaction kettle and adding the deionized water, stirring and bubbling under protection of an inert gas to remove oxygen in this solution, and heating until the oxalate being completely dissolved to obtain an oxalate solution; where when a heating temperature in the reaction kettle reaches a preset value, the mixed bimetallic solution is added dropwise into the reaction kettle at a certain flow rate, and a manganese iron oxalate suspension is obtained after a reaction is carried out at a constant temperature for a period of time.

S3, after the reaction, taking out of the manganese iron oxalate suspension, filtering, washing and vacuum drying, to obtain a manganese iron oxalate precursor powder.

S4, weighing the manganese iron oxalate precursor, a lithium source and carbon sources according to a chemical molar ratio, adding a solvent for grinding.

S5, after grinding, spray drying a ground slurry to obtain a spray material.

S6, loading the spray material into a graphite sagger according to a certain mass, high temperature sintering reaction under protection of the inert gas, to obtain a sintered material.

S7, adjusting pulverization parameters and pulverizing the sintered material, to obtain the cathode material of lithium manganese iron phosphate powder.

Preferably, the iron salt in S1 includes, but is not limited to, one or more of ferrous nitrate, ferrous sulfate, ferrous acetate, and ferrous chloride; and the ferrous sulfate is ferrous sulfate without crystalline water or with the crystalline water.

Preferably, the manganese salt in S1 includes, but is not limited to, one or more of manganese nitrate, manganese sulfate, manganese acetate, and manganese chloride; and the manganese sulfate is manganese sulfate without crystalline water or with the crystalline water.

Preferably, the molar ratio of the manganese salt to the iron salt in S1 is 1:1-5, the mixed bimetallic solution has a concentration of 0.3-1.5 mol/L; a molar ratio of the mixed bimetallic solution to the oxalate in S2 is 1: 1-1.5, and the oxalate solution has a concentration of 0.8-2.0 mol/L.

Preferably, the oxalate in S2 includes, but is not limited to, one or more of oxalic acid, ammonium oxalate, sodium oxalate, and potassium oxalate; and the inert gas for bubbling in S2 is one of argon, nitrogen, or helium.

Preferably, in S2, the stirring has a speed of 100-1000 r/min, the heating temperature in the reaction kettle is 20-100 °C, the flow rate of dropwise the mixed bimetallic solution is 0.1-10 L/min, and the reaction is carried out under 20-80 °C for 0.5-48 h; and in S3, the vacuum drying is performed under 20-120 °C for 0.5-24 h.

Preferably, in S4, the lithium source is one or more of lithium carbonate, lithium hydroxide, and lithium dihydrogen phosphate; the carbon source is one or more of glucose, sucrose, citric acid, phenolic resin, polyethylene glycol, starch; and the solvent is one of water, methanol, ethanol and acetone. And in S4, a molar ratio of the manganese iron oxalate precursor to the lithium source is 1:1-1.2, and a mass ratio of a sum of a mass of the manganese iron oxalate precursor and the lithium source to a mass of one of the carbon sources is 1:0.01-0.1, and a time for grinding is 30-180 min.

Preferably, in S5, the spray drying is performed under an inlet air temperature of 165-205 °C, an outlet temperature of 75-85 °C and an atomizer with a frequency of 150-250 Hz. In S6, a loading capacity of the graphite sagger is 1-8.5 kg, the high temperature sintering reaction is performed under 750-800 °C for 5-30 h. In S7, the pulverizing is performed under a pressure of 350-450 Kpa by using a classifier with a frequency of 150-250Hz, a discharging motor with a frequency of 40-50 Hz, and a fan with a frequency of 20-30 Hz.

In a second aspect, in some embodiments of the present disclosure, the present disclosure provides a cathode material of composite carbon-coated lithium manganese iron phosphate, prepared by the method described in the first aspect of the present disclosure.

In a third aspect, the present disclosure provides a use of the cathode material of the composite carbon-coated lithium manganese iron phosphate, which is used as electrode materials for lithium-ion batteries, and specific application steps are as follows.

The cathode material of lithium manganese iron phosphate is made into a CR2032 type button battery for charging /discharging test. Active substances, acetylene black, and PVDF are weighted according to a mass ratio of 8:1:1, mixed evenly with a solvent of N-methyl-2-pyrrolidone (NMP), coated on an aluminum foil and vacuum drying under 100 °C for 2 h, to obtain a positive plate. In an argon-protected glove box, a lithium sheet is used as a negative plate, LiPF₆ is dissolved in a mixed solvent of ethylene carbonate, dimethyl carbonate, and ethyl methyl carbonate according to a volume ratio of 1:1:1 to obtain an electrolyte with a concentration of 1.0 mol/L, a porous polypropylene film is used a diaphragm. The positive plate, the negative plate, the electrolyte, and the diaphragm are assembled into the button battery, and electrochemical testing is performed on a Land electrochemistry meter.

The present disclosure has at least the following advantages and beneficial effects.

The method for preparing the cathode material of the composite carbon-coated lithium manganese iron phosphate of the present disclosure, firstly, by a co-precipitation reaction of the mixed bimetallic solution containing the manganese and iron salts with the oxalic solution, and then filtering, washing and drying, to obtain the manganese iron oxalate precursor; secondly, the manganese iron oxalate precursor is mixed with the lithium source and carbon sources, and then grinding, spray drying, sintering and pulverizing, to obtain the cathode material of lithium manganese iron phosphate. This method has advantages of simple process, easy industrialized large-scale production, good economic benefits, low manufacturing cost, etc., which can effectively improve the charging/discharging specific capacity of the cathode material of lithium manganese iron phosphate. Moreover, this method also can solve the problems of poor electronic conductivity and low lithium-ion diffusion rate by coating lithium manganese iron phosphate with the composite carbon sources.

### BRIEF DESCRIPTION OF THE DRAWINGS

FIG. 1 shows an X-ray diffraction (XRD) image of Mn_{0.6}Fe_{0.4}C₂O₄·2H₂O in accordance with Example 1 of the present disclosure.
FIG. 2 shows an X-ray diffraction (XRD) image of LiMn_{0.6}Fe_{0.4}PO₄ in accordance with Example 1 of the present disclosure.
FIG. 3 shows a scanning electron microscope (SEM) image of LiMn_{0.6}Fe_{0.4}PO₄ in accordance with Example 1 of the present disclosure.
FIG. 4 shows a charging and discharging curve of LiMn_{0.6}Fe_{0.4}PO₄ in Example 1 and lithium manganese iron phosphate in comparative example 1 of the present disclosure, in which the solid line represents LiMn_{0.6}Fe_{0.4}PO₄, and the dotted line represents lithium manganese iron phosphate prepared in comparative example 1.
FIG. 5 shows a scanning electron microscope (SEM) image of LiMn_{0.7}Fe_{0.3}PO₄ in accordance with Example 2 of the present disclosure.
FIG. 6 shows a scanning electron microscope (SEM) image of LiMn_{0.8}Fe_{0.2}PO₄ in accordance with Example 2 of the present disclosure.

### DETAILED DESCRIPTION OF THE EMBODIMENTS

The technical solutions in the embodiments of the present disclosure shall be described clearly and completely below, and it is obvious that the described embodiments are only a part of the embodiments of the present disclosure and not all of the embodiments. Based on the embodiments in the present disclosure, all other embodiments obtained by a person of ordinary skill in the art without creative labor shall fall within the scope of protection of the present invention.

The technical solutions of the present disclosure are described in detail as follows.

In some embodiments of the present disclosure, a method for preparing a cathode material of composite carbon-coated lithium manganese iron phosphate is disclosed, including the following steps of S1 to S7.

S1, weighing a manganese salt and an iron salt according to a molar ratio, and adding deionized water to completely dissolve, to obtain a mixed bimetallic solution.

S2, weighing an oxalate according to a molar ratio of the manganese salt to the iron salt, putting the oxalate in a reaction kettle and adding the deionized water, stirring and bubbling under protection of an inert gas to remove oxygen in this solution, and heating until the oxalate being completely dissolved; where when a heating temperature in the reaction kettle reaches a preset value, the mixed bimetallic solution is added dropwise into the reaction kettle at a certain flow rate, and a manganese iron oxalate suspension is obtained after a reaction is carried out at a constant temperature for a period of time.

S3, after the reaction, taking out of the manganese iron oxalate suspension, filtering, washing and vacuum drying, to obtain a manganese iron oxalate precursor powder.

S4, weighing the manganese iron oxalate precursor, a lithium source and carbon sources according to a chemical molar ratio, adding a solvent for grinding.

S5, after grinding, spray drying a ground slurry to obtain a spray material.

S6, loading the spray material into a graphite sagger according to a certain mass, high temperature sintering reaction under protection of the inert gas, to obtain a sintered material.

S7, adjusting pulverization parameters and pulverizing the sintered material, to obtain the cathode material of lithium manganese iron phosphate powder.

Preferably, the iron salt in S1 includes, but is not limited to, one or more of ferrous nitrate, ferrous sulfate, ferrous acetate, and ferrous chloride; and the ferrous sulfate is ferrous sulfate without crystalline water or with the crystalline water.

More preferably, the iron salt in S1 is ferrous sulfate heptahydrate.

Preferably, the manganese salt in S1 includes, but is not limited to, one or more of manganese nitrate, manganese sulfate, manganese acetate, and manganese chloride; and the manganese sulfate is manganese sulfate without crystalline water or with the crystalline water.

More preferably, the manganese salt in S1 is manganese sulfate monohydrate.

Preferably, the molar ratio of the manganese salt to the iron salt in S1 is 1:1-5, the mixed bimetallic solution has a concentration of 0.3-1.5 mol/L.

Preferably, the oxalate in S2 includes, but is not limited to, one or more of oxalic acid, ammonium oxalate, sodium oxalate, and potassium oxalate.

More preferably, the oxalate in S2 is oxalic acid dihydrate.

Preferably, the mixed bimetallic solution to the oxalate in S2 is 1:1-1.5, and an oxalate solution has a concentration of 0.8-2.0 mol/L.

Preferably, the inert gas for bubbling in S2 is one of argon, nitrogen, or helium.

Preferably, in S2, the stirring has a speed of 100-1000 r/min.

Preferably, in S2, the heating temperature in the reaction kettle is 20-100 °C, the flow rate of dropwise the mixed bimetallic solution is 0.1-10 L/min.

Preferably, in S2, the reaction is carried out under 20-80 °C for 0.5-48 h.

Preferably, in S3, the vacuum drying is performed under 20-120 °C for 0.5-24 h.

Preferably, in S4, the lithium source is one or more of lithium carbonate, lithium hydroxide, and lithium dihydrogen phosphate.

More preferably, the lithium source is lithium dihydrogen phosphate.

Preferably, in S4, the carbon source is one or more of glucose, sucrose, citric acid, phenolic resin, polyethylene glycol, starch; and the solvent is one of water, methanol, ethanol and acetone.

More preferably, in S4, the carbon source is glucose and polyethylene glycol.

Preferably, in S4, the solvent is one of water, methanol, ethanol and acetone.

More preferably, in S4, the solvent is methanol.

Preferably, in S4, a molar ratio of the manganese iron oxalate precursor to the lithium source is 1:1-1.2, and a mass ratio of a sum of a mass of the manganese iron oxalate precursor and the lithium source to a mass of one of the carbon sources is 1:0.01-0.1.

Preferably, a time for grinding is 30-180 min.

Preferably, in S5, the spray drying is performed under an inlet air temperature of 165-205 °C, an outlet temperature of 75-85 °C and an atomizer with a frequency of 150-250 Hz.

Preferably, in S6, a loading capacity of the graphite sagger is 1-8.5 kg, the high temperature sintering reaction is performed under 750-800 °C for 5-30 h.

Preferably, in S6, the inert gas is one of argon, nitrogen and helium.

More preferably, in S6, the inert gas is nitrogen.

Preferably, in S7, the pulverizing is performed under a pressure of 350-450 Kpa by using a classifier with a frequency of 150-250Hz, a discharging motor with a frequency of 40-50 Hz, and a fan with a frequency of 20-30 Hz.

The cathode material of composite carbon-coated lithium manganese iron phosphate prepared by the above method is made into a lithium-ion battery and tested as described below.

The cathode material of lithium manganese iron phosphate is made into a CR2032 type button battery for charging /discharging test. Active substances, acetylene black, and PVDF are weighted according to a mass ratio of 8:1:1, mixed evenly with a solvent of N-methyl-2-pyrrolidone (NMP), coated on an aluminum foil and vacuum drying under 100 °C for 2 h, to obtain a positive plate. In an argon-protected glove box, a lithium sheet is used as a negative plate, LiPF₆ is dissolved in a mixed solvent of ethylene carbonate, dimethyl carbonate, and ethyl methyl carbonate according to a volume ratio of 1:1:1 to obtain an electrolyte with a concentration of 1.0 mol/L, a porous polypropylene film is used a diaphragm. The positive plate, the negative plate, the electrolyte, and the diaphragm are assembled into the button battery, and electrochemical testing is performed on a Land electrochemistry meter.

Based on above methods, the present disclosure provides the following partial examples.

### Example 1

A cathode material of composite carbon-coated lithium manganese iron phosphate, having a chemical formula LiMn_{0.6}Fe_{0.4}PO₄, prepared by the following method including steps of S1 to S7.

S1, 8.9 kg ferrous sulfate heptahydrate and 8.11 kg manganese sulfate monohydrate are weighted in a stirring tank according to a molar ratio of 4:6, and then deionized water is added with stirred to dissolve the two, so as to obtain a mixed bimetallic solution with a concentration of 1.0 mol/L ready for use.

S2, 10.89 kg oxalic acid is weighed in a reaction kettle and the deionized water is added, then under the protection of nitrogen, it is stirring with 400 r/min and bubbling to remove oxygen in this solution in the reaction kettle, and then the solution is heated at 60 °C until the oxalic acid is completely dissolved to obtain an oxalic acid solution with a concentration of 1.08 mol/L. When a heating temperature in the reaction kettle is stabilized at 60 °C, the mixed bimetallic solution is added dropwise to the reaction kettle at a flow rate of 1.6 L/min, after dropwise addition of the mixed bimetallic solution is completed, this reaction is continued at 60 °C for 8 h to obtain a manganese iron oxalate suspension.

S3, after the reaction, the manganese iron oxalate suspension is taken out from the reaction kettle, filtered under pressure and washed repeatedly with the deionized water, and then vacuum dried at 80 °C for 12 h, to obtain a manganese iron oxalate precursor powder.

S4, 10.5 kg manganese iron oxalate precursor powder, 6.26 kg lithium dihydrogen phosphate, 0.73 kg dextrose, and 0.26 kg polyethylene glycol are weighed, and 20 L methanol is added for grinding 120 min, to obtain a ground slurry.

S5, the ground slurry is spray dried, with an inlet air temperature at 180 °C, an outlet temperature at 80 °C, and an atomizer with a frequency of 220 Hz, to obtain a spray material.

S6, 8.0 kg the spray material is loaded in a graphite sagger, and then sintered at 780 °C for 10 h under the protection of nitrogen, to obtain a sintered material.

S7, the sintered material is pulverized with a pulverizing pressure of 430 Kpa, a classifier with a frequency of 190 Hz, a discharging motor with a frequency of 45 Hz, and a fan with a frequency of 25 Hz, to obtain the cathode material of lithium manganese iron phosphate.

### Example 2

A cathode material of composite carbon-coated lithium manganese iron phosphate, having a chemical formula LiMn_{0.7}Fe_{0.3}PO₄, prepared by the following method including steps of S1 to S7.

S1, 6.67 kg ferrous sulfate heptahydrate and 9.47 kg manganese sulfate monohydrate are weighted in a stirring tank according to a molar ratio of 3:7, and then deionized water is added with stirred to dissolve the two, so as to obtain a mixed bimetallic solution with a concentration of 1.0 mol/L ready for use.

S2, 10.89 kg oxalic acid is weighed in a reaction kettle and the deionized water is added, then under the protection of nitrogen, it is stirring with 400 r/min and bubbling to remove oxygen in this solution in the reaction kettle, and then the solution is heated at 60 °C until the oxalic acid is completely dissolved to obtain an oxalic acid solution with a concentration of 1.08 mol/L. When a heating temperature in the reaction kettle is stabilized at 60 °C, the mixed bimetallic solution is added dropwise to the reaction kettle at a flow rate of 1.6 L/min, after dropwise addition of the mixed bimetallic solution is completed, this reaction is continued at 60 °C for 8 h to obtain a manganese iron oxalate suspension.

S3, after the reaction, the manganese iron oxalate suspension is taken out from the reaction kettle, filtered under pressure and washed repeatedly with the deionized water, and then vacuum dried at 80 °C for 12 h, to obtain a manganese iron oxalate precursor powder.

S4, 10.4 kg manganese iron oxalate precursor powder, 6.20 kg lithium dihydrogen phosphate, 0.72 kg dextrose, and 0.26 kg polyethylene glycol are weighed, and 20 L methanol is added for grinding 120 min, to obtain a ground slurry.

S5, the ground slurry is spray dried, with an inlet air temperature at 180 °C, an outlet temperature at 80 °C, and an atomizer with a frequency of 220 Hz, to obtain a spray material.

S6, 8.0 kg the spray material is loaded in a graphite sagger, and then sintered at 780 °C for 10 h under the protection of nitrogen, to obtain a sintered material.

S7, the sintered material is pulverized with a pulverizing pressure of 430 Kpa, a classifier with a frequency of 190 Hz, a discharging motor with a frequency of 45 Hz, and a fan with a frequency of 25 Hz, to obtain the cathode material of lithium manganese iron phosphate.

### Example 3

A cathode material of composite carbon-coated lithium manganese iron phosphate, having a chemical formula LiMn_{0.8}Fe_{0.2}PO₄, prepared by the following method including steps of S1 to S7.

S1, 4.45 kg ferrous sulfate heptahydrate and 10.82 kg manganese sulfate monohydrate are weighted in a stirring tank according to a molar ratio of 2:8, and then deionized water is added with stirred to dissolve the two, so as to obtain a mixed bimetallic solution with a concentration of 1.0 mol/L ready for use.

S2, 10.89 kg oxalic acid is weighed in a reaction kettle and the deionized water is added, then under the protection of nitrogen, it is stirring with 400 r/min and bubbling to remove oxygen in this solution in the reaction kettle, and then the solution is heated at 60 °C until the oxalic acid is completely dissolved to obtain an oxalic acid solution with a concentration of 1.08 mol/L. When a heating temperature in the reaction kettle is stabilized at 60 °C, the mixed bimetallic solution is added dropwise to the reaction kettle at a flow rate of 1.6 L/min, after dropwise addition of the mixed bimetallic solution is completed, this reaction is continued at 60 °C for 8 h to obtain a manganese iron oxalate suspension.

S3, after the reaction, the manganese iron oxalate suspension is taken out from the reaction kettle, filtered under pressure and washed repeatedly with the deionized water, and then vacuum dried at 80 °C for 12 h, to obtain a manganese iron oxalate precursor powder.

S4, 11.44 kg manganese iron oxalate precursor powder, 6.82 kg lithium dihydrogen phosphate, 0.79 kg dextrose, and 0.29 kg polyethylene glycol are weighed, and 20 L methanol is added for grinding 120 min, to obtain a ground slurry.

S5, the ground slurry is spray dried, with an inlet air temperature at 180 °C, an outlet temperature at 80 °C, and an atomizer with a frequency of 220 Hz, to obtain a spray material.

S6, 8.0 kg the spray material is loaded in a graphite sagger, and then sintered at 780 °C for 10 h under the protection of nitrogen, to obtain a sintered material.

S7, the sintered material is pulverized with a pulverizing pressure of 430 Kpa, a classifier with a frequency of 190 Hz, a discharging motor with a frequency of 45 Hz, and a fan with a frequency of 25 Hz, to obtain the cathode material of lithium manganese iron phosphate.

### Comparative Example 1

The comparative example 1 differs from the Example 1 in that the carbon source used is only glucose.

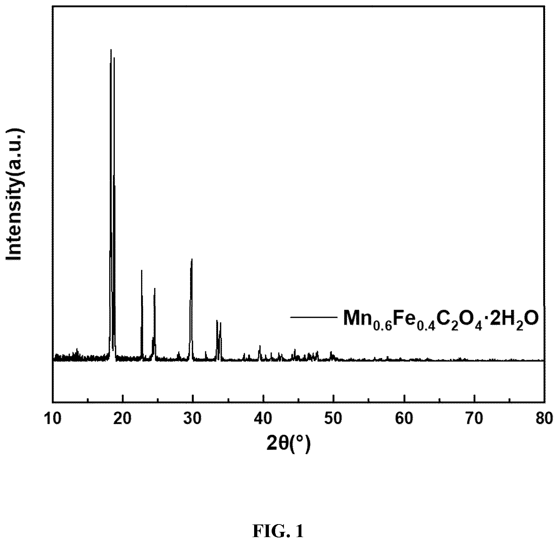

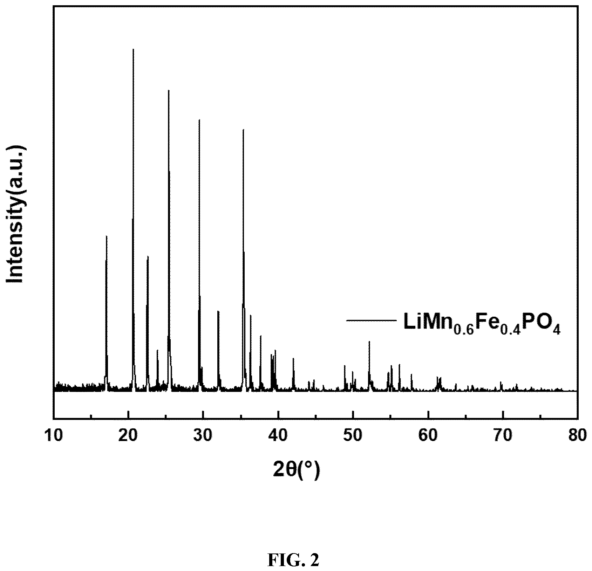

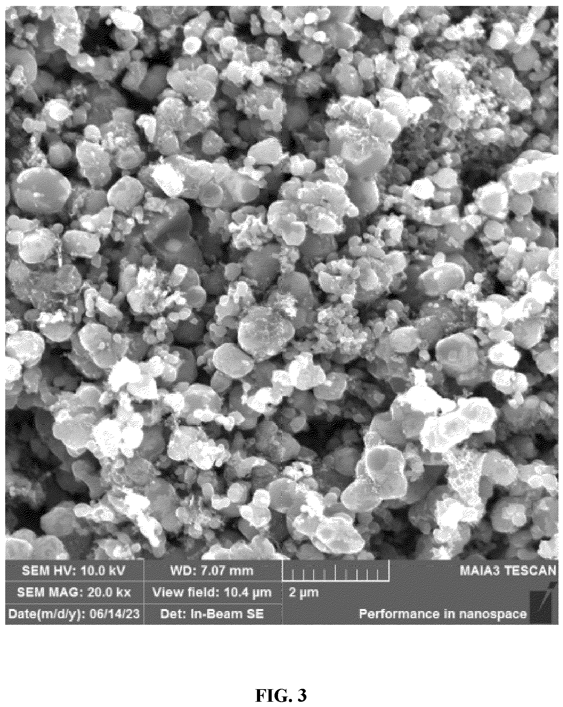

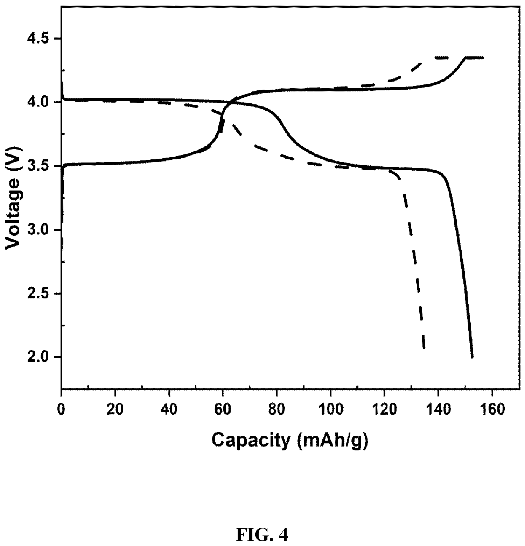

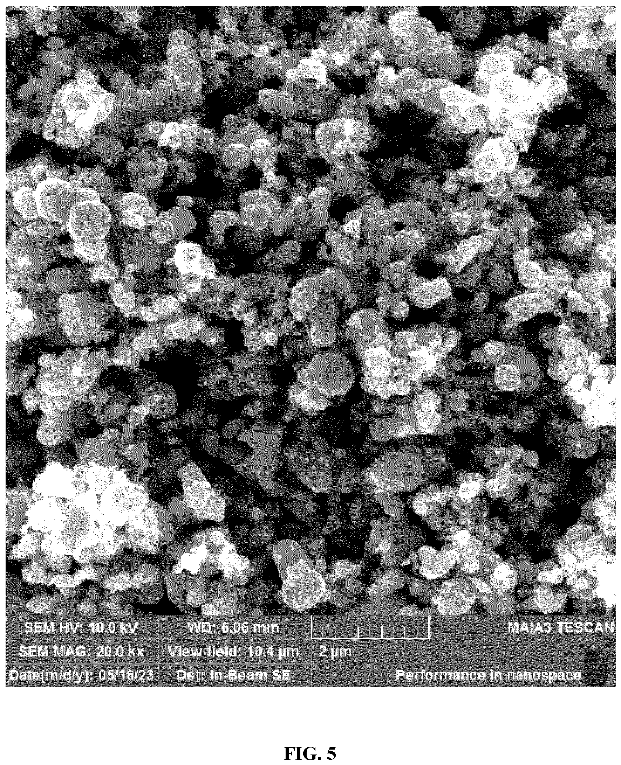

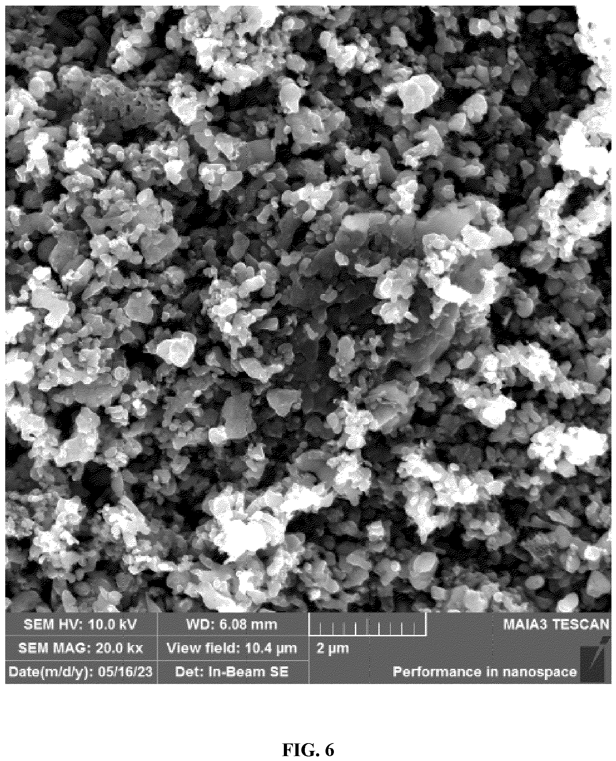

A series of tests are performed on the cathode materials prepared in Examples 1-3 and the comparative example 1, the results are shown in FIG. 1 to FIG. 6. As can be seen from the charging/discharging curve of FIG. 4, the composite carbon-coated lithium manganese iron phosphate of Example 1 of the present disclosure has better electrochemical performance, due to better high-temperature graphitization of the composite carbon, a good conductive network is constructed, which can improve the electronic conductivity and thus improve the electrochemical performance.

The above shows and describes the basic principles of the present disclosure, the main features and the advantages of the present disclosure, and it is apparent to one of ordinary skill in the art that, the present disclosure is not limited to the details of the above exemplary embodiments, and that it is capable of being realized in other specific forms without departing from the concept or the basic features of the present invention. Accordingly, the embodiments are to be regarded as exemplary and non-limiting in any point of view, and the scope of the present invention is limited by the appended claims and not by the foregoing description, and is therefore intended to encompass all variations falling within the meaning and scope of the equivalent elements of the claims.

Although embodiments of the present disclosure have been shown and described, it will be understood to one of ordinary skill in the art that a variety of changes, modifications, substitutions and variations may be made to these embodiments without departing from the principle and concept of the present invention, the scope of which is limited by the appended claims and their equivalents.

## Claims

1. A method for preparing a cathode material of composite carbon-coated lithium manganese iron phosphate, comprising steps of:
S1, weighing a manganese salt and an iron salt according to a molar ratio, and adding deionized water to completely dissolve, to obtain a mixed bimetallic solution;
S2, weighing an oxalate according to a molar ratio of the manganese salt to the iron salt, putting the oxalate in a reaction kettle and adding the deionized water, stirring and bubbling under protection of an inert gas to remove oxygen in this solution, and heating until the oxalate being completely dissolved to obtain an oxalate solution; wherein when a heating temperature in the reaction kettle reaches a preset value, the mixed bimetallic solution is added dropwise into the reaction kettle at a certain flow rate, and a manganese iron oxalate suspension is obtained after a reaction is carried out at a constant temperature for a period of time;
S3, after the reaction, taking out of the manganese iron oxalate suspension, filtering, washing and vacuum drying, to obtain a manganese iron oxalate precursor powder;
S4, weighing the manganese iron oxalate precursor, a lithium source and carbon sources according to a chemical molar ratio, adding a solvent for grinding;
S5, after grinding, spray drying a ground slurry to obtain a spray material;
S6, loading the spray material into a graphite sagger, high temperature sintering reaction under protection of the inert gas, to obtain a sintered material; and
S7, adjusting pulverization parameters and pulverizing the sintered material, to obtain a cathode material of lithium manganese iron phosphate powder.

2. The method according to claim 1, wherein the iron salt in S1 comprises one or more of ferrous nitrate, ferrous sulfate, ferrous acetate, and ferrous chloride; and the ferrous sulfate is ferrous sulfate without crystalline water or with the crystalline water.

3. The method according to claim 1, wherein the manganese salt in S1 comprises one or more of manganese nitrate, manganese sulfate, manganese acetate, and manganese chloride; and the manganese sulfate is manganese sulfate without crystalline water or with the crystalline water.

4. The method according to claim 1, wherein the molar ratio of the manganese salt to the iron salt in S1 is 1:1-5, the mixed bimetallic solution has a concentration of 0.3-1.5 mol/L; a molar ratio of the mixed bimetallic solution to the oxalate in S2 is 1:1-1.5, and the oxalate solution has a concentration of 0.8-2.0 mol/L.

5. The method according to claim 1, wherein the oxalate in S2 comprises one or more of oxalic acid, ammonium oxalate, sodium oxalate, and potassium oxalate; and the inert gas for bubbling in S2 is one of argon, nitrogen, or helium.

6. The method according to claim 1, wherein in S2, the stirring has a speed of 100-1000 r/min, the heating temperature in the reaction kettle is 20-100 °C, the flow rate of dropwise the mixed bimetallic solution is 0.1-10 L/min, and the reaction is carried out under 20-80 °C for 0.5-48 h; and in S3, the vacuum drying is performed under 20-120 °C for 0.5-24 h.

7. The method according to claim 1, wherein in S4, the lithium source is one or more of lithium carbonate, lithium hydroxide, and lithium dihydrogen phosphate; the carbon source is one or more of glucose, sucrose, citric acid, phenolic resin, polyethylene glycol, starch; and the solvent is one of water, methanol, ethanol and acetone; and
wherein in S4, a molar ratio of the manganese iron oxalate precursor to the lithium source is 1:1-1.2, and a mass ratio of a sum of a mass of the manganese iron oxalate precursor and the lithium source to a mass of one of the carbon sources is 1:0.01-0.1, and a time for grinding is 30-180 min.

8. The method according to claim 1, wherein in S5, the spray drying is performed under an inlet air temperature of 165-205 °C, an outlet temperature of 75-85 °C and an atomizer with a frequency of 150-250 Hz;
wherein in S6, a loading capacity of the graphite sagger is 1-8.5 kg, the high temperature sintering reaction is performed under 750-800 °C for 5-30 h; and
wherein in S7, the pulverizing is performed under a pressure of 350-450 Kpa by using a classifier with a frequency of 150-250Hz, a discharging motor with a frequency of 40-50 Hz, and a fan with a frequency of 20-30 Hz.

9. A cathode material of composite carbon-coated lithium manganese iron phosphate, prepared by the method of any one of claims 1-8.

10. The cathode material of composite carbon-coated lithium manganese iron phosphate according to claim 9, having a chemical formula LiMnₓFe_{y}PO₄, wherein 0.5<x<1, 0<y≤0.5, and 0.5<x+y≤1.

11. The cathode material of composite carbon-coated lithium manganese iron phosphate according to claim 10, wherein x + y =1.

12. The cathode material of composite carbon-coated lithium manganese iron phosphate according to claim 9, wherein the chemical formula comprises LiMn_{0.6}Fe_{0.4}PO₄, LiMn_{0.7}Fe_{0.3}PO₄, and LiMn_{0.8}Fe_{0.2}PO₄.

13. Use of the cathode material of composite carbon-coated lithium manganese iron phosphate according to claim 9, wherein the cathode material of composite carbon-coated lithium manganese iron phosphate is used as electrode materials for lithium-ion batteries.
